# EUROPÄISCHE PATENTSCHRIFT

(11) **EP 1 374 293 B1**
(45) Veröffentlichungstag und Bekanntmachung des Hinweises auf die Patenterteilung: **18.01.2006**
(21) Anmeldenummer: 02719646.8
(22) Anmeldetag: 28.02.2002
(51) Int. Cl.: H01L 21/28, H01L 21/336

(54) **VERFAHREN ZUR HERSTELLUNG EINES MOSFETS MIT SEHR KLEINER KANALLÄNGE**
METHOD FOR THE PRODUCTION OF A MOSFET WITH VERY SMALL CHANNEL LENGTH
PROCEDE POUR LA PRODUCTION D'UN TRANSISTOR MOSFET A LONGUEUR DE CANAL TRES FAIBLE

(30) Priorität: 26.03.2001 DE 10114778
(43) Veröffentlichungstag der Anmeldung: 02.01.2004
(73) Patentinhaber: Infineon Technologies AG, 81669 München (DE)
(72) Erfinder: CAPPELLANI, Annalisa, Portland, OR 97229 (US); DITTMAR, Ludwig, 01139 Dresden (DE); SCHUMANN, Dirk, 16567 Schönfliess (DE)
(74) Vertreter: Epping - Hermann - Fischer
(86) Internationale Anmeldenummer: PCT/DE2002/000732
(87) Internationale Veröffentlichungsnummer: WO 2002/078058

(56) Entgegenhaltungen:
- EP-A- 0 328 350
- EP-A- 0 740 334
- WO-A-02/41383
- FR-A- 2 791 177
- US-A- 5 089 863
- US-A- 6 091 120
- HISAMOTO D ET AL: "A LOW-RESISTANCE SELF-ALIGNED T-SHAPED GATE FOR HIGH PERFORMANCE SUB-0.1-MUM CMOS" IEEE TRANSACTIONS ON ELECTRON DEVICES, IEEE INC. NEW YORK, US, Bd. 44, Nr. 6, 1. Juni 1997 (1997-06-01), Seiten 951-956, XP000658312 ISSN: 0018-9383 in der Anmeldung erwähnt
- PATENT ABSTRACTS OF JAPAN vol. 012, no. 256 (E-635), 19. Juli 1988 (1988-07-19) & JP 63 044768 A (MITSUBISHI ELECTRIC CORP), 25. Februar 1988 (1988-02-25)

## Beschreibung

Die vorliegende Erfindung betrifft ein Verfahren zur Herstellung eines MOSFETs mit einem Gate-Kanal einer vorgegebenen, sehr kleinen Kanallänge.

Transistoren mit Gate-Kanallängen unterhalb von 100 nm, sogenannte Kurzkanaltransistoren im Sub-µ-Bereich, sind mit herkömmlichen Technologien nur schwierig so exakt herzustellen, daß die erforderlichen elektrischen Betriebsparameter eingehalten werden. Eine hohe Performance des Transistors setzt beispielsweise einen hohen Betriebsstrom bei geringer Leistungsaufnahme sowie einen nur geringen Leckstrom im Off-Zustand voraus. Ferner sollen der Gate-Widerstand und parasitäre Effekte wie die Miller-Kapazität möglichst gering sein.

Dies erfordert maßgenaue Abmessungen und Proportionen des durch die Abfolge vieler Prozeßschritte geformten Transistors. Besondere Schwierigkeiten bereitet derzeit die Herstellung T-förmiger Gate-Schichtenstapel, deren untere Schicht entsprechend der gewünschten Kanallänge sehr schmal ist im Vergleich zu der oberen Schicht des Gate-Schichtenstapels.

Zur Herstellung von T-Gate-Transistoren sind verschiedene Verfahren vorgeschlagen worden. So ist z.B. die Herstellung eines T-Gates bekannt, bei dem eine Metallschicht nachträglich auf ein vorgeformtes Polysilizium-Gate abgeschieden wird. Aufgrund von Lagefehlern zwischen den Schichten muß jedoch der Abstand der Source/Drain-Kontakte zum Gate erhöht werden, um auch bei einer Dejustierung einen einwandfreien Betrieb des Transistors zu gewährleisten. Dies bringt jedoch einen erhöhten Source/Drain-Widerstand mit sich.

Ein Kurzkanaltransistor wird z. B. Ghani, Ahmed et al., IEDM 99, Seite 415, beschrieben. Ferner beschreiben D. Hisamoto et al. (IEEE Transaction on Electronic Devices, Vol 44, 6, 97, S. 951) ein Verfahren zur Herstellung eines selbstjustierten T-Gates mit einer Wolfram-Schicht auf einer darunterliegenden ersten Gate-Schicht. Auch Kasai et al. (IEDM 94, S. 497 - 498) beschreiben ein Verfahren zur Herstellung eines T-Gates, bei dem der Gate-Schichtenstapel aus übereinander abgeschiedenem Polysilizium, einer Diffusionsbarriere und einer Metallschicht besteht.

Nachteilhaft ist bei letzteren Verfahren, daß das Kurzkanal-Gate mit Hilfe aufwendiger lithographischer Methoden, etwa mit Hilfe eines Elektronenstrahls, strukturiert werden muß.

Das Dokument FR 2791177 offenbart ein Verfahren zur Bildung einer T-förmigen Gate-Elektrode mittels seitlicher Unterätzung. Die untere, seitlich eingesenkte Schicht besteht aus Silizium. Die darüber angeordnete Schicht besteht aus einem Metall. Eine weitere Schicht dazwischen ist nicht vorgesehen.

Es ist die Aufgabe der vorliegenden Erfindung, ein Verfahren bereitzustellen, mit dem ein T-Gate-Transistor sehr kurzer Kanallänge maßgenau, auf sehr einfache Weise und kostengünstig hergestellt werden kann.

Die Lösung dieser Aufgabe erfolgt mit den Merkmalen des Anspruch 1.

Erfindungsgemäß werden verschiedene Ätzschritte unterschiedlichen Isotropiegrades in geeigneter Weise miteinander verknüpft, um die gewünschte T-förmige Struktur des Gate zu erhalten. Zunächst wird der Gate-Schichtenstapel anisotrop geätzt, wodurch dieser strukturiert wird. Das so geformte Gate ist noch deutlich breiter als die vorgegebene Kanallänge.

Im Gegensatz zu herkömmlichen Verfahren wird nicht zuerst versucht, eine untere Gate-Schicht derselben Breite der vorgegebenen Kanallänge zu formen, sondern erfindungsgemäß wird zunächst ein breiterer und daher mit Hilfe herkömmlicher preiswerter Lithographieschritte formbarer Schichtenstapel erzeugt. Dadurch wird das Verfahren besonders kostengünstig.

Zunächst wird die zweite Gate-Schicht in der Weise maskiert, daß ihre Breite größer ist als die vorgegebene Kanallänge; d.h. die Maskierung erfolgt in der Weise, daß nach im nachfolgenden ersten Ätzschritt ein aus der ersten und der zweiten Gate-Schicht bestehender Schichtenstapel erzeugt wird, der eine Breite besitzt, die größer als die vorgegebene Kanallänge ist.

Die weitere Bearbeitung des Gate-Schichtenstapels zum Erreichen der der vorgegebenen Kanallänge entsprechenden kleinen Gate-Länge erfolgt dann durch nachträgliches Ätzen der unteren Gate-Schicht von der Seite her.

Dazu wird erfindungsgemäß ein zweiter Ätzschritt durchgeführt. Um die durch die zweite Gate-Schicht verdeckte erste Gate-Schicht zu erreichen, wird die zweite Ätzung isotrop durchgeführt. Aufgrund ihrer Isotropie bewirkt die zweite Ätzung eine seitliche Einschnürung der ersten Gate-Schicht, welche kontrolliert bis auf die vorgegebene Kanallänge verschmälert wird. Das so erhaltene Kurzkanal-Gate entsteht dabei mit Hilfe einfacher und an sich bekannter Prozeßschritte, ohne daß aufwendige Verfahren zum Einsatz kommen.

Eine bevorzugte Ausführungsart sieht vor, daß die Breite der ersten Gate-Schicht durch die Breite der zweiten Gate-Schicht und durch die Dauer des kontrollierten seitlichen Unterätzens der ersten Gate-Schicht unter die zweite Gate-Schicht kontrolliert wird. Im einfachsten Fall bleiben die Konzentration von Ätzstoffen sowie sonstige Parameter der Unterätzung konstant, so daß lediglich die Zeitdauer dieser Ätzung die untere Gate-Länge bestimmt. Die vorgegebene Breite der ersten Gate-Schicht ist dabei vorzugsweise gleich der vorgegebenen Kanallänge.

Eine Weiterbildung der Erfindung sieht vor, daß die Breite der ersten Gate-Schicht während des Unterätzens mit Hilfe der Konzentration eines Ätzstoffes kontrolliert wird. Dabei kann die Konzentration auf einen während der Ätzung konstanten Wert eingestellt oder auch im Verlaufe der Ätzung verändert werden.

Vorzugsweise ist vorgesehen, daß das anisotrope Ätzen der zweiten und der ersten Gate-Schicht bis zum Erreichen des Dielektrikums fortgesetzt wird. Dadurch wird die beim isotropen Ätzen entstehende Seitenwand besonders gleichförmig. Andererseits kann die erste, isotrope Ätzung auch innerhalb der unteren Gate-Schicht beendet und dort die zweite, isotrope Ätzung begonnen werden. In diesem Fall wird das Dielektrikum erst während der zweiten Ätzung erreicht.

Schließlich ist vorgesehen, daß das isotrope seitliche Unterätzen der ersten Gate-Schicht selektiv zur zweiten Gate-Schicht erfolgt. Dadurch bleiben die oberen Abmessungen der Gate-Leitung erhalten und können so leichter kontaktiert werden.

Die Unterätzung wird mit Hilfe eines isotropen Plasmaätzschrittes durchgeführt. Dabei kommen herkömmliche Trockenätzkammern mit induktiver oder sonstiger Einkopplung zum Einsatz.

Als Ätzgas für die isotrope Ätzung dient, wegen seiner guten Selektivität gegenüber Metallen Bromwasserstoff.

Hinsichtlich der Abmessungen des hergestellten T-Gates sehen bevorzugte Ausführungsformen vor, daß die Breite der zweiten Gate-Schicht zwischen 120 und 300 nm und daß die Breite der ersten Gate-Schicht zwischen 30 und 150 nm beträgt. Vorzugsweise werden damit Transistoren mit einer Kanallänge von 30 bis 150 nm hergestellt.

Das Gate-Dielektrikum enthält vorzugsweise Siliziumdioxid.

Vorzugsweise besitzt die zweite Gate-Schicht eine höhere elektrische Leitfähigkeit als die erste Gate-Schicht. Dadurch wird die Leitfähigkeit des Gate insgesamt erhöht. Die zweite Gate-Schicht umfaßt als Metall vorzugsweise Wolfram. Sie kann aus Wolfram bestehen.

Eine Weiterbildung der Erfindung sieht das Einbringen von Source/Drain-Implantationen und deren Diffundieren unter die vorgegebene Breite der zweiten Gate-Schicht bis zum Rand der ersten Gate-Schicht vor. Hierbei bildet die breitere, obere Gate-Schicht einen Teil einer Maske, die die Implantationen erst in einem gewissen Abstand von der unteren Gate-Schicht durch das Dielektrikum in den Wafer einbringen läßt. Das anschließende thermische Verteilen der Implantationen wird so gesteuert, daß die Dotierstoffe zusätzlich zur Breite eines Spacers ebenfalls die Differenz der Breiten der zweiten und der ersten Gate-Schicht, d. h. den Weg zur vorgegebenen kleinen Kanallänge, zurücklegen.

Das Vorzugsweise ist der erfindungsgemäße MOSFET Teil eines DRAMs oder einer Logikschaltung.

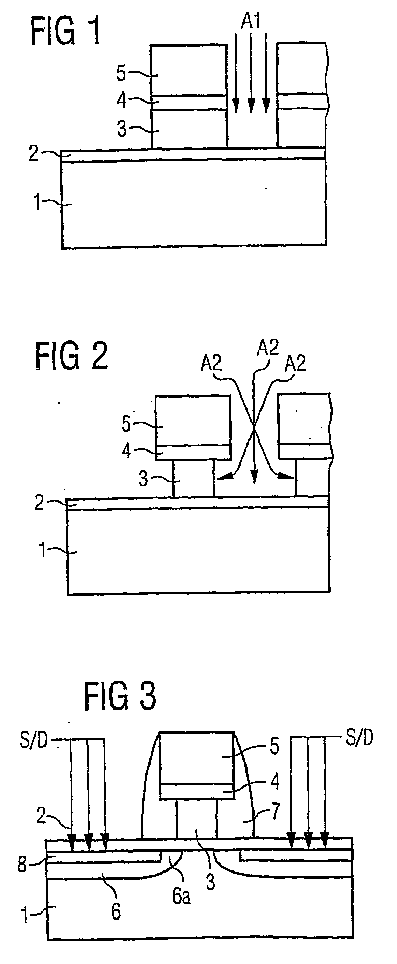

Die Erfindung wird nachstehend mit Bezug auf die Figuren 1 bis 3 beschrieben, die verschiedene Verfahrensstufen der erfindungsgemäßen Herstellung von T-Gate-Transistoren darstellen.

Gemäß Figur 1 wird auf einem mit einem Gate-Oxid 2 aus vorzugsweise Siliziumdioxid bedeckten Siliziumsubstrat 1 eine Folge mehrerer Gate-Schichten abgeschieden. Der so erzeugte Gate-Schichtenstapel besteht im wesentlichen aus einer ersten Gate-Schicht 3 aus Polysilizium und einer darüberliegenden zweiten Gate-Schicht 5. Die zweite Gate-Schicht 5 dient zur Verbesserung der Leitfähigkeit des Gate bei sehr kleinen Abmessungen und wird daher vorzugsweise aus einem Metall, insbesondere aus Wolfram bestehen.

Zwischen diesen Schichten kann eine als Diffusionsbarriere dienende Zwischenschicht 4 aus beispielsweise Wolframnitrid erzeugt werden, etwa durch nachträgliche Silizidierung. Auch können insgesamt mehr als zwei Schichten aufeinander abgeschieden werden. Entscheidend ist, daß mindestens zwei Gate-Schichten aus unterschiedlichem Material gebildet werden, die eine seitliche Unterätzung der unteren Schicht unter die obere Schicht des Gate zulassen.

Wenn die für die Gate-Struktur benötigte Schichtenfolge erzeugt ist, wird diese lateral strukturiert, um das Gate zu formen. Dazu wird die Schichtenfolge bzw. ihre oberste Schicht 5, zunächst maskiert. Da diese Maskierung in der Weise erfolgt, daß die Breite der zweiten Gate-Schicht 5 in diesem Verfahrensstadium breiter ist als die vorgegebene Kanallänge, können herkömmliche lithographische Techniken wie etwa die Verwendung von Lack- oder Hartmasken zum Einsatz kommen.

Erfindungsgemäß wird die anfängliche Breite des Gate-Schichtenstapels bewußt breiter gewählt, als es der gewünschten Gate-Länge und damit der Kanallänge entspricht. Dafür wird durch die Verknüpfung einer anisotropen ersten Ätzung mit einer anschließenden, anisotropen Unterätzung, die bei dieser Reihenfolge zu einer Unterätzung der ersten Gate-Schicht unter die zweite Gate-Schicht führt, eine Reduzierung der Gate-Länge unmittelbar auf dem Gateoxid erreicht. Durch diese Verknüpfung kann mithilfe an sich bekannter und einfacher Ätzvorgänge ein T-Gate sehr kurzer Kanallänge hergestellt werden. Der Einsatz von Lasern oder Elektronenstrahlen, die üblicherweise zur Erzeugung sehr kleiner Strukturen zur Anwendung kommen, ist bei dem erfindungsgemäßen Verfahren nicht erforderlich. Vielmehr kann die zweite Gate-Schicht 5 mithilfe von Lackmasken oder Hartmasken in üblicher Weise maskiert werden.

Die Formung des Gate beginnt dann mit der anisotropen, in Richtung senkrecht auf die Substratoberfläche gerichteten Trockenätzung mit Hilfe eines ersten Ätzgases, angedeutet durch A1 in Figur 1. Die Ätzung wird vorzugsweise so lange fortgesetzt, bis alle Gate-Schichten strukturiert sind, aber das darunterliegende Dielektrikum noch nicht durchbrochen ist.

Alternativ kann die Ätzung auch in einem Stadium beendet werden, in dem die zweite Gate-Schicht 5 ganz, die erste Gate-Schicht 3 hingegen nur teilweise durchbrochen ist. In diesem Fall erfolgt die vollständige Durchbrechung der ersten Gate-Schicht 3 bis hin zum Dielektrikum 2 durch den zweiten, nachstehend beschriebenen Ätzschritt.

Gemäß Figur 2 wird in einem nächsten, isotropen Ätzschritt ein zweites Ätzgas A2 isotrop dem Substrat zugeführt. Isotrop in diesem Sinne bedeutet, daß der Isotropiegrad ausreichend groß ist, daß das Ätzgas A2 die Seitenwände der unteren Gate-Schicht 3 erreicht und unterätzt.

Die zweite Ätzung muß selektiv zum Dielektrikum 2 erfolgen. Je größer die Selektivität der zweiten Ätzung gegenüber dem Dielektrikum ist, um so zuverlässiger wird ein Durchbrechen des Dielektrikums verhindert.

Das Dielektrikum braucht nicht notwendigerweise schon im Laufe der ersten Ätzung erreicht zu werden; falls die anfängliche Breite der Gate-Struktur, d.h. die Breite der oberen Gate-Schicht 5 ausreichend groß ist, ist auch vorstellbar, daß nach Erreichen der unteren Gate-Schicht 3 erst die zweite Ätzung das Dielektrikum freilegt.

Das Ätzgas A2 kann vorzugsweise so ausgewählt werden, daß die zweite Ätzung auch selektiv zu der über der ersten Gate-Schicht 3 liegenden zweiten Gate-Schicht 5 (und gegebenenfalls zur zwischen ihnen liegenden Zwischenschicht) erfolgt. In diesem Falle entstehen T-förmige Gate-Strukturen, deren gut leitender metallischer oberer Teil seinen nach der ersten Ätzung geformten breiteren Querschnitt beibehält, während nur die untere erste Gate-Schicht 3 verschmälert wird. Dadurch kann die obere Gate-Schicht 5 leichter kontaktiert werden.

Sofern die zweite Ätzung nicht selektiv zur oberen Gate-Schicht ist, entstehen zwar keine T-förmigen Gate-Strukturen; jedoch wird auch hier dieselbe Reduzierung der anfänglichen Gate-Länge erreicht. Bei ausreichend dick abgeschiedener zweiter Gate-Schicht 5 bleibt zudem auch nach der zweiten Ätzung genügend Material dieser Schicht vorhanden, um das eine ausreichende elektrische Leitfähigkeit des Gate zu gewährleisten und um das Gate zuverlässig zu kontaktieren.

Als Ätzgas A2 für die zweite, isotrop durchgeführte Ätzung dient vorzugsweise ein Halogenwasserstoff. Insbesondere Bromwasserstoff (HBr) ist wegen seiner guten Selektivität gegenüber Siliziumdioxid (als Dielektrikum) und gegenüber Metallen (als zweiter Gate-Schicht) gut geeignet.

In den Figuren 1 und 2 sind Gate-Schichtenstapel benachbarter Kondensatoren übertrieben eng benachbart dargestellt, um den Einfluß unterschiedlicher Isotropiegrade auf die Formgebung durch das Ätzgas A2 besser zu verdeutlichen.

Figur 3 zeigt hingegen nur noch einen einzigen hergestellten T-förmigen Schichtenstapel 3, 4, 5, der seitlich bereits mit Spacern 7 bedeckt ist. Die Spacer dienen zur seitlichen Isolierung des Gate-Kanals gegenüber den einzubringenden Source/Drain-Implantationen S/D.

Die Implantationen S/D werden außerhalb der Spacer 7 durch das Dielektrikum 2 hindurch in Bereiche 8 des Substrats implantiert. Beim einer anschließenden thermischen Bearbeitung werden die Temperatur und die Dauer der Wärmeeinwirkung so gesteuert, daß sich das Ionenprofil 6 bis unter die obere Gate-Schicht 5 an die untere Gate-Schicht 3 heran, d.h. in den Bereich 6a hinein erstreckt. Bei einer Breite des ursprünglichen Gate-Schichtenstapels von 200 nm genügt eine der Unterätzung entsprechende zusätzliche Ionendiffusion von 50 nm auf jeder Seite des Gate, um einen Transistor einer Kanallänge von 100 nm zu formen. Vorzugsweise werden - ausgehend von einer Gate-Breite von 120 bis 300 nm - die Source/Drain-Implantationen auf vorzugsweise 30 bis 150 nm (entsprechend der gewünschten Kanallänge) aneinander herangeführt. Erfindungsgemäß können jedoch MOSFETs beliebiger, noch kürzerer Kanallänge hergestellt werden.

Ein solcher Transistor kann mit dem erfindungsgemäßen Verfahren mithilfe herkömmliche Lithographiemethoden erzeugt werden.

Mit Hilfe der vorliegenden Erfindung gelingt eine Herstellung selbstjustierter Mehrschichten-Gates, bei denen ausschließlich herkömmliche Herstellungsanlagen und Prozeßschritte zum Einsatz kommen. Das Verfahren ist daher einfach und kostengünstig, und aufgrund der kontrollierten Unterätzung ist die Gate-Länge der hergestellten Transistoren besonders maßgenau.

## Patentansprüche

1. Verfahren zur Herstellung eines MOSFETs mit einem Gate-Kanal einer vorgegebenen, sehr kleinen Kanallänge, mit den Schritten:
- Erzeugen eines Dielektrikums (2) auf einem Halbleitersubstrat (1),
- Aufbringen einer ersten Gate-Schicht (3), die Polysilizium umfaßt, auf das Dielektrikum (2),
- Bilden einer als Diffusionsbarriere dienenden Zwischenschicht (4) aus beispielsweise Wolframnitrid auf der ersten Gate-Schicht (3),
- Aufbringen einer zweiten Gate-Schicht (5), die Wolfram umfaßt,
- Maskieren der zweiten Gate-Schicht (5) in der Weise, daß die Breite der zweiten Gate-Schicht (5) größer ist als die vorgegebene Kanallänge,
- anisotropes Ätzen der zweiten Gate-Schicht (5), der Zwischenschicht (4) und der ersten Gate-Schicht (3),
- isotropes seitliches Unterätzen der ersten Gate-Schicht (3) unter die zweite Gate-Schicht (5) selektiv zum Dielektrikum (2), zur Zwischenschicht (4) und zur zweiten Gate-Schicht (5) mittels eines Bromwasserstoff umfassenden Ätzgases in einem Plasma-Trockenätzprozeß in kontrollierter Weise derart, daß eine vorgegebene Breite der ersten Gate-Schicht (3) erreicht wird, die kleiner als die Breite der zweiten Gate-Schicht (5) ist und die der vorgegebenen Kanallänge entspricht.

2. Verfahren nach Anspruch 1,
**dadurch gekennzeichnet, daß**
die Breite der ersten Gate-Schicht (3) durch die Breite der zweiten Gate-Schicht (5) und durch die Dauer des seitlichen Unterätzens der ersten Gate-Schicht (3) unter die zweite Gate-Schicht (5) kontrolliert wird.

3. Verfahren nach Anspruch 1 oder 2,
**dadurch gekennzeichnet , daß**
die Breite der ersten Gate-Schicht (3) während des Unterätzens mit Hilfe der Konzentration des Bromwasserstoffes (A2) kontrolliert wird.

4. Verfahren nach einem der Ansprüche 1 bis 3,
**dadurch gekennzeichnet , daß**
das anisotrope Ätzen der zweiten (5) und der ersten Gate-Schicht (3) bis zum Erreichen des Dielektrikums (2) fortgesetzt wird.

5. Verfahren nach einem der Ansprüche 1 bis 4,
**dadurch gekennzeichnet, daß**
die Breite der zweiten Gate-Schicht (5) zwischen 120 und 300 nm beträgt.

6. Verfahren nach einem der Ansprüche 1 bis 5,
**dadurch gekennzeichnet, daß**
die Breite der ersten Gate-Schicht (3) zwischen 30 und 150 nm beträgt.

7. Verfahren nach einem der Ansprüche 1 bis 6,
**dadurch gekennzeichnet, daß**
das Gate-Dielektrikum (2) Siliziumdioxid umfaßt.

8. Verfahren nach einem der Ansprüche 1 bis 7,
**dadurch gekennzeichnet, daß**
die zweite Gate-Schicht (5) eine höhere elektrische Leitfähigkeit besitzt als die erste Gate-Schicht (3).

9. Verfahren nach einem der Ansprüche 1 bis 8,
**gekennzeichnet durch**
Einbringen von Source/Drain-Implantationen (S/D) und Diffundieren der Implantationen unter die vorgegebene Breite der zweiten Gate-Schicht (5) bis zum Rand der ersten Gate-Schicht (3).

10. Verfahren nach einem der Ansprüche 1 bis 9,
**dadurch gekennzeichnet, daß**
die Bildung der Zwischenschicht (4) eine nachträgliche Silizidierung umfaßt.

## Claims

1. Method for fabricating a MOSFET having a gate channel of a predetermined, very small channel length, having the steps of:
- producing a dielectric (2) on a semiconductor substrate (1),
- applying a first gate layer (3), comprising polysilicon, to the dielectric (2),
- forming an intermediate layer (4) serving as a diffusion barrier and made of tungsten nitride, for example, on the first gate layer (3),
- applying a second gate layer (5), comprising tungsten,
- masking the second gate layer (5) in such a way that the width of the second gate layer (5) is greater than the predetermined channel length,
- anisotropically etching the second gate layer (5), the intermediate layer (4) and the first gate layer (3),
- isotropically laterally undercutting the first gate layer (3) under the second gate layer (5) selectively with respect to the dielectric (2), with respect to the intermediate layer (4) and with respect to the second gate layer (5) by means of an etching gas comprising hydrogen bromide in a plasma dry etching process in a controlled manner such that a predetermined width of the first gate layer (3) is achieved, which is less than the width of the second gate layer (5) and which corresponds to the predetermined channel length.

2. Method according to Claim 1,
**characterized in that**
the width of the first gate layer (3) is controlled by the width of the second gate layer (5) and by the duration of the lateral undercutting of the first gate layer (3) under the second gate layer (5).

3. Method according to Claim 1 or 2,
**characterized in that**
the width of the first gate layer (3) is controlled during the undercutting with the aid of the concentration of the hydrogen bromide (A2).

4. Method according to one of Claims 1 to 3,
**characterized in that**
the anisotropic etching of the second (5) and of the first gate layer (3) is continued until the dielectric (2) is reached.

5. Method according to one of Claims 1 to 4,
**characterized in that**
the width of the second gate layer (5) is between 120 and 300 nm.

6. Method according to one of Claims 1 to 5,
**characterized in that**
the width of the first gate layer (3) is between 30 and 150 nm.

7. Method according to one of Claims 1 to 6,
**characterized in that**
the gate dielectric (2) comprises silicon dioxide.

8. Method according to one of Claims 1 to 7,
**characterized in that**
the second gate layer (5) has a higher electrical conductivity than the first gate layer (3).

9. Method according to one of Claims 1 to 8,
**characterized by**
introduction of source/drain implantations (S/D and diffusion of the implantations under the predetermined width of the second gate layer (5) as far as the edge of the first gate layer (3).

10. Method according to one of Claims 1 to 9,
**characterized in that**
the formation of the intermediate layer (4) comprises a subsequent siliciding.

## Revendications

1. Procédé de production d'un MOSFET ayant un canal de grille d'une longueur de canal prescrite très petite, comprenant les stades dans lesquels :
- on produit un diélectrique (2) sur un substrat (1) semi-conducteur,
- on dépose une première couche (3) de grille qui comprend du polysilicium sur le diélectrique (2),
- on forme une couche (4) intermédiaire par exemple en nitrure de tungstène servant de barrière de diffusion sur la première couche (3) de grille,
- on dépose une deuxième couche (5) de grille qui comprend du tungstène,
- on masque la deuxième couche (5) de grille, de manière à ce que la largeur de la deuxième couche (5) de grille soit plus grande que la longueur de canal prescrite,
- on attaque de façon anisotrope la deuxième couche (5) de grille, la couche (4) intermédiaire et la première couche (3) de grille,
- on effectue une attaque latérale isotrope par en dessous de la première couche (3) de grille sous la deuxième couche (5) de grille sélectivement par rapport au diélectrique (2), par rapport à la couche (4) intermédiaire et par rapport à la deuxième couche (5) de grille, au moyen d'un gaz d'attaque comprenant du bromure d'hydrogène dans une opération d'attaque à sec au plasma de façon contrôlée, de manière à obtenir une largeur prescrite de la première couche (3) de grille qui est plus petite que la largeur de la deuxième couche (5) de grille et qui correspond à la longueur de canal prescrite.

2. Procédé suivant la revendication 1,
**caractérisé en ce que**
l'on contrôle la largeur de la première couche: (3) de grille par la largeur de la deuxième couche (5) de grille et par la durée de l'attaque latérale par en dessous de la première couche (3) de grille sous la deuxième couche (5) de grille.

3. Procédé suivant la revendication 1 ou 2,
**caractérisé en ce que**
l'on contrôle la largeur de la première couche (3) de grille pendant l'attaque par en dessous à l'aide de la concentration du bromure d'hydrogène (A2).

4. Procédé suivant l'une des revendications 1 à 3,
**caractérisé en ce que**
l'on poursuit l'attaque anisotrope de la deuxième couche (5) de grille et de la première couche (3) de grille jusqu'à ce que le diélectrique (2) soit atteint.

5. Procédé suivant l'une des revendications 1 à 4,
**caractérisé en ce que**
la largeur de la deuxième couche (5) de grille est comprise entre 120 et 300 nm.

6. Procédé suivant l'une des revendications 1 à 5,
**caractérisé en ce que**
la largeur de la première couche (3) de grille est comprise entre 30 et 150 nm.

7. Procédé suivant l'une des revendications 1 à 6,
**caractérisé en ce que**
le diélectrique (2) de grille comprend du dioxyde de silicium.

8. Procédé suivant l'une des revendications 1 à 7,
**caractérisé en ce que**
la deuxième couche (5) de grille a une conductivité électrique plus grande que la première couche (3) de grille.

9. Procédé suivant l'une des revendications 1 à 8,
**caractérisé par**
introduction d'implantations (S/D) de source/drain et diffusion des implantations sous la largeur prescrite de la deuxième couche (5) de grille jusqu'au bord de la première couche (3) de grille.

10. Procédé suivant l'une des revendications 1 à 9,
**caractérisé en ce que**
la formation de la couche (4) intermédiaire comprend une siliciuration ultérieure.
